# EUROPÄISCHE PATENTANMELDUNG

(11) **EP 0 843 353 A1**
(43) Veröffentlichungstag der Anmeldung: **20.05.1998**
(21) Anmeldenummer: 97119060.8
(22) Anmeldetag: 31.10.1997
(51) Int. Cl.: H01L 21/8247, H01L 21/822, H01L 27/115

(54) **Verfahren zur Herstellung einer elektrisch schreib- und löschbaren Festwertspeicherzellenanordnung**

(30) Priorität: 11.11.1996 DE 19646419
(71) Anmelder: SIEMENS AKTIENGESELLSCHAFT, 80333 München (DE)
(72) Erfinder: Krautschneider, Wolfgang, Dr., 83104 Hohenthann (DE); Hofmann, Franz, Dr., 80995 München (DE); Reisinger, Hans, Dr., 82031 Grünwald (DE); Willer, Josef, Dr., 85521 Riemerling (DE)

(57) **Zusammenfassung**

Durch selbstjustierende Prozeßschritte wird eine Festwertspeicherzellenanordnung mit Speicherzellen, die jeweils einen MOS-Transistor mit einem floatenden Gate (7'') aufweisen, hergestellt. Die MOS-Transistoren sind in parallel verlaufenden Zeilen angeordnet. Benachbarte Zeilen verlaufen dabei jeweils abwechselnd am Boden von Längsgräben und zwischen benachbarten Längsgräben. Die Kontrollgates umgeben die floatenden Gates (7'') seitlich, so daß auch die Speicherzellen am Boden der Längsgräben ein Coupling ratio > 1 aufweisen. Es wird ein Flächenbedarf pro Speicherzelle von 2F² (F: minimale Strukturgröße) erreicht.

## Beschreibung

Für viele Anwendungen werden Festwertspeicherzellenanordnungen mit elektrisch schreibbaren und elektrisch löschbaren Festwertspeicherzellen in Siliziumtechnologie, sogenannte Flash-EEPROM, benötigt. Diese Flash-EEPROM-Anordnungen erhalten die gespeicherten Daten auch ohne Spannungsversorgung.

Technisch werden diese Speicherzellen meist durch einen MOS-Transistor realisiert, der auf dem Kanalbereich ein erstes Dielektrikum, ein floatendes Gate, ein zweites Dielektrikum und ein Kontrollgate aufweist. Ist auf dem floatenden Gate eine Ladung gespeichert, so beeinflußt diese die Schwellenspannung des MOS-Transistors. In einer solchen Speicherzellenanordnung wird der Zustand 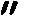 Ladung auf dem floatenden Gate" einem ersten logischen Wert, der Zustand 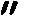 keine Ladung auf dem floatenden Gate" einem zweiten logischen Wert zugeordnet. Die Information wird in die Speicherzellen über einen Fowler-Nordheim-Tunnelstrom, durch den Elektronen auf das floatende Gate injiziert werden, eingeschrieben. Gelöscht wird die Information durch einen Tunnelstrom in entgegengesetzter Richtung durch das erste Dielektrikum.

Die MOS-Transistoren sind in derartigen Speicherzellenanordnungen als planare MOS-Transistoren ausgebildet und in einer planaren Zellarchitektur angeordnet. Dadurch beträgt der theoretisch minimale Flächenbedarf einer Speicherzelle 4F², wobei F die kleinste herstellbare Strukturgröße in der jeweiligen Technologie ist. Derzeit werden derartige Flash-EEPROM-Anordnungen für Datenmengen von maximal 64 Mbit angeboten.

In EP 0 673 070 A2 ist eine EEPROM-Anordnung vorgeschlagen worden, in der planare MOS-Transistoren im Sinne einer NAND-Logik in Reihe verschaltet sind. Dabei sind miteinander verbundene Source/Drain-Gebiete von benachbarten MOS-Transistoren als gemeinsames dotiertes Gebiet ausgebildet. Die EEPROM-Anordnung ist in einem Halbleitersubstrat realisiert, das an einer Hauptfläche mit streifenförmigen, parallel verlaufenden Gräben versehen ist. Die in Reihe geschalteten MOS-Transistoren sind jeweils am Boden der Gräben bzw. zwischen benachbarten Gräben an der Hauptfläche des Substrats angeordnet. Benachbarte Reihen von MOS-Transistoren sind durch die Seitenwand der Gräben und an der Seitenwand der Gräben vorgesehene isolierende Spacer gegeneinander isoliert. Die floatenden Gates der am Grabenboden angeordneten MOS-Transistoren füllen die Grabenweite jeweils aus. Bedingt durch die an den Seitenwänden der Gräben angeordneten isolierenden Spacer ist die Breite der floatenden Gates an der Grenzfläche zum zweiten Dielektrikum geringfügig größer als an der Grenzfläche zum ersten Dielektrikum. Damit weist die bekannte EEPROM-Anordnung ein Coupling ratio nahe Eins auf. Unter Coupling ratio wird der Quotient aus der Kapazität zwischen Kontrollgate und floatendem Gate und der Kapazität zwischen floatendem Gate und Kanalbereich bezeichnet.

Der Erfindung liegt das Problem zugrunde, ein Verfahren zur Herstellung einer EEPROM-Anordnung anzugeben, bei dem eine hohe Packungsdichte und ein erhöhtes Coupling ratio erzielt wird.

Dieses Problem wird erfindungsgemäß gelöst durch ein Verfahren gemäß Anspruch 1. Weitere Ausgestaltungen der Erfindung gehen aus den übrigen Ansprüchen hervor.

In einer Hauptfläche eines Halbleitersubstrates wird ein von einem ersten Leitfähigkeitstyp dotiertes Gebiet erzeugt, das gegenüber dem Halbleitersubstrat isoliert ist. Die Isolation des vom ersten Leitfähigkeitstyps dotierten Gebietes gegenüber dem Halbleitersubstrat kann sowohl in einem pn-Übergang als auch in einer vergrabenen, isolierenden Schicht, zum Beispiel der vergrabenen isolierenden Schicht eines SOI-Substrates, bestehen. Die Isolation bewirkt, daß an das vom ersten Leitfähigkeitstyp dotierte Gebiet eine Spannung angelegt werden kann.

In der Hauptfläche werden innerhalb des vom ersten Leitfähigkeitstyp dotierten Gebietes im wesentlichen parallel verlaufende Längsgräben geätzt. Es werden eine Vielzahl in Zeilen angeordnete Speicherzellen, die jeweils mindestens einen MOS-Transistor umfassen, erzeugt. Die Zeilen werden abwechselnd an der Hauptfläche zwischen benachbarten Längsgräben und am Boden der Längsgräben angeordnet.

Es wird zum Beispiel nach einer TEOS-Abscheidung und Spacer-Ätzung eine erste dielektrische Schicht und darauf eine erste dotierte Polysiliziumschicht erzeugt. An den Teilen der ersten Polysiliziumschicht, die an den Flanken der Längsgräben angeordnet sind, werden Spacer gebildet. Auf freiliegenden Teilen der ersten Polysiliziumschicht wird eine Hilfsschicht erzeugt, zu der die Spacer und die erste Polysiliziumschicht selektiv ätzbar sind.

Vorzugsweise werden die Spacer aus Siliziumnitrid gebildet. Die Hilfsschicht wird dann durch thermische Oxidation selektiv an der freiliegenden Oberfläche der ersten Polysiliziumschicht erzeugt.

Alternativ werden die Spacer aus SiO₂ gebildet, das selektiv zu thermischem Siliziumoxid ätzbar ist. In einem TEOS-Verfahren abgeschiedenes SiO₂ ist beispielsweise naßchemisch im Verhältnis 1:3 selektiv zu thermischem Siliziumoxid ätzbar. Die Hilfsschicht wird dann durch thermische Oxidation gebildet. Dabei entsteht auch an der Oberfläche der Spacer eine dünne Schicht aus thermischem Oxid, deren Dicke jedoch viel geringer ist als an der Oberfläche der ersten Polysiliziumschicht und die mit den Spacern entfernt wird. Diese Ausführungsform hat den Vorteil, daß mechanische Spannungen, die bei der Verwendung von Siliziumnitrid auftreten können, vermieden werden.

Anschließend werden die Spacer selektiv zur Hilfsschicht entfernt. Durch Ätzen der ersten Polysiliziumschicht unter Verwendung der Hilfsschicht als Ätzmaske werden streifenförmige erste Polysiliziumstrukturen gebildet, die, bedingt durch die Form der Hilfsschicht, parallel zu den Längsgräben jeweils an der Hauptfläche zwischen benachbarten Längsgräben und am Boden der Längsgräben angeordnet sind. Die Breite der am Boden der Längsgräben angeordneten ersten Polysiliziumstrukturen ist dabei geringer als die Grabenweite, so daß in den Längsgräben die Flanken der ersten Polysiliziumstruktur freiliegen. Die Breite der ersten Polysiliziumstruktur in den Längsgräben wird über die Dicke der ersten Polysiliziumschicht eingestellt. Die Strukturierung der ersten Polysiliziumschicht erfolgt selbstjustiert, das heißt, ohne Einsatz von photolithographisch erzeugten Masken.

Die Hilfsschicht wird entfernt. Es werden Isolationsstrukturen gebildet, die am Boden der Längsgräben jeweils zwischen der dort angeordneten ersten Polysiliziumstruktur und den Grabenwänden angeordnet sind und deren Höhe geringer ist als die Höhe der ersten Polysiliziumstrukturen.

Es wird eine zweite dielektrische Schicht erzeugt. Durch Abscheiden und Strukturieren einer zweiten Polysiliziumschicht werden Kontrollgates und quer zu den Zeilen verlaufende Wortleitungen erzeugt. Die Kontrollgates werden so gebildet, daß sie auch die Flanken der in den Längsgräben angeordneten ersten Polysiliziumstrukturen bedecken. Die Wortleitungen sind jeweils mit den Kontrollgates von entlang unterschiedlichen Zeilen angeordneten MOS-Transistoren verbunden.

Zur Bildung der floatenden Gates werden anschließend die zweite dielektrische Schicht und die erste Polysiliziumstruktur durch anisotropes Ätzen entsprechend den Wortleitungen strukturiert. Es wird eine Source/Drain-Implantation für die MOS-Transistoren durchgeführt, bei der die Wortleitungen als Maske wirken.

Da die Flanken der ersten Polysiliziumstrukturen, aus denen die floatenden Gates gebildet werden, und damit der floatenden Gates mit der zweiten dielektrischen Schicht und den Kontrollgates bedeckt sind, ist die Kapazität zwischen den Kontrollgates und den floatenden Gates größer als die Kapazität zwischen den floatenden Gates und dem Kanalbereich. Daher wird ein Coupling ratio größer 1 erzielt.

Zur Herstellung der Festwertspeicherzellenanordnung werden zwei photolithographisch erzeugte Masken mit jeweils streifenförmigen Öffnungen benötigt: die erste zur Bildung der Längsgräben, die zweite zur Strukturierung der zweiten Polysiliziumschicht bei der Bildung der Kontrollgates und der Wortleitungen. Die Justierung der Masken ist gegeneinander unproblematisch. Werden die streifenförmigen Öffnungen mit einer Weite und einem Abstand von jeweils einer in der jeweiligen Technologie minimal herstellbaren Strukturgröße F gebildet, so beträgt der Platzbedarf pro Speicherzelle 2F².

Vorzugsweise werden an den Seitenwänden der Längsgräben vor der Bildung der ersten dotierten Polysiliziumschicht Spacer gebildet. Dadurch wird die Breite der ersten Polysiliziumstrukturen, die in den Längsgräben angeordnet sind, durch die Dicke der ersten dotierten Polysiliziumschicht und die Breite der Spacer bestimmt. Auf diese Weise kann die Dicke der ersten dotierten Polysiliziumschicht unabhängig von der Breite der jeweils in den Längsgräben angeordneten ersten Polysiliziumstrukturen eingestellt werden. Vorzugsweise werden die Spacer aus einem Material gebildet, zu dem Polysilizium selektiv ätzbar ist. Sie wirken dann bei der Strukturierung der ersten dotierten Polysiliziumschicht als Ätzstop und schützen die Seitenwände der Längsgräben vor einem Ätzangriff. Die Spacer werden zum Beispiel aus SiO₂ gebildet.

Im folgenden wird die Erfindung anhand eines Ausführungsbeispiels, das in den Figuren dargestellt ist, näher erläutert.
- Figur 1: zeigt einen Schnitt durch ein Halbleitersubstrat mit Längsgräben, einer ersten dielektrischen Schicht, einer ersten dotierten Polysiliziumschicht, Si₃N₄-Spacer und einer Maske aus thermischem SiO₂.
- Figur 2: zeigt das Substrat nach Bildung einer ersten Polysiliziumstruktur.
- Figur 3: zeigt das Substrat nach Bildung von Isolationsstrukturen, einer zweiten dielektrischen Schicht, Kontrollgates und Wortleitungen.
- Figur 4: zeigt den in Figur 3 mit IV-IV bezeichneten Schnitt.
- Figur 5: zeigt den in Figur 3 mit V-V bezeichneten Schnitt.
- Figur 6: zeigt eine Aufsicht auf die Speicherzellenanordnung, in der die in Figur 3, Figur 4 und Figur 5 dargestellten Schnitte mit III-III, IV-IV und V-V bezeichnet sind.

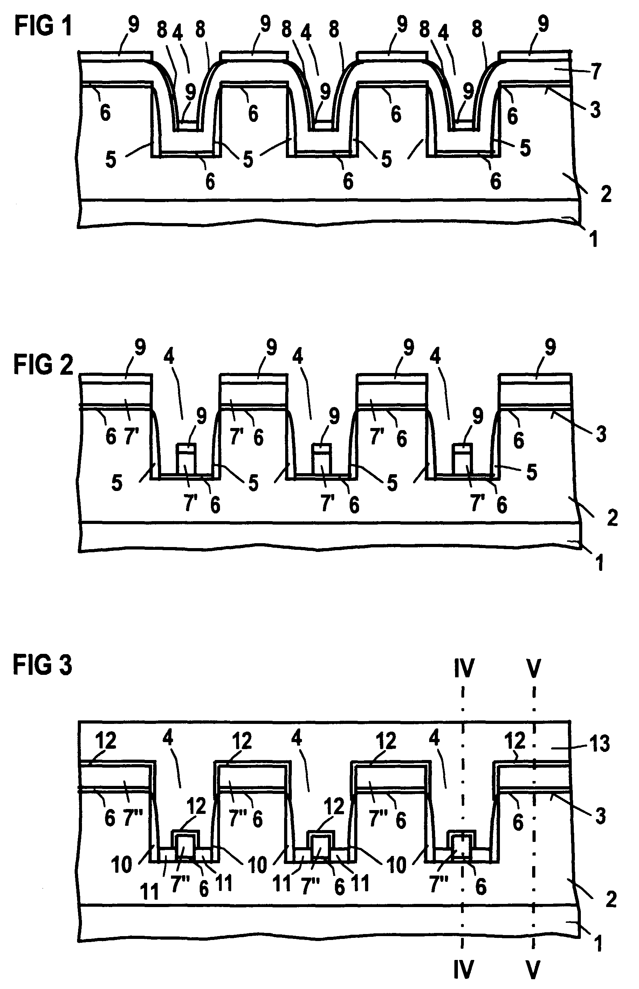

In einem Substrat 1 aus zum Beispiel monokristallinem Silizium mit einer n-Dotierung von 5 x 10¹⁵ cm⁻³ wird zunächst eine p-dotierte Wanne 2, zum Beispiel durch maskierte Implantation, erzeugt. Die p-dotierte Wanne 2 weist eine Dotierstoffkonzentration von zum Beispiel 5 x 10¹⁶ cm⁻³ auf. Die p-dotierte Wanne 2 grenzt an eine Hauptfläche 3 des Substrats 1 an (siehe Figur 1). Sie weist eine Tiefe von zum Beispiel 1,2 µm auf.

Durch Abscheidung einer SiO₂-Schicht in einem TEOS-Verfahren und deren photolithographische Strukturierung wird eine Grabenmaske erzeugt (nicht dargestellt). Durch anisotropes Ätzen zum Beispiel Cl₂ werden unter Verwendung der Grabenmaske als Ätzmaske Längsgräben 4 geätzt. Die Längsgräben 4 weisen eine Tiefe von zum Beispiel 0,5 µm auf. Dabei liegt der Grabenboden der Längsgräben 4 in der p-dotierten Wanne 2. Die Breite der Längsgräben 4 beträgt zum Beispiel 0,4 µm, die Länge zum Beispiel 25 µm. Die Längsgräben 4 verlaufen parallel über das Substrat 1. Ihre Ausdehnung und Anzahl ist so groß, daß sie den Bereich für später herzustellende Speicherzellen überdecken. Es werden zum Beispiel 1024 Längsgräben nebeneinander angeordnet.

Anschließend wird die Grabenmaske naßchemisch zum Beispiel mit Flußsäure oder in einem Trockenätzprozeß zum Beispiel mit CHF₃ entfernt. Dann wird eine SiO₂-Schicht zum Beispiel in einem TEOS-Verfahren in einer Dicke von zum Beispiel 40 nm bis 100 nm abgeschieden. Durch anisotropes Ätzen werden aus der SiO₂-Schicht SiO₂-Spacer 5 an den Seitenwänden der Längsgräben 4 gebildet. Dabei wird die Oberfläche der p-dotierten Wanne am Grabenboden und zwischen benachbarten Längsgräben 4 im Bereich der Hauptfläche 3 freigelegt.

Anschließend wird eine erste dielektrische Schicht 6 durch thermische Oxidation gebildet. Die erste dielektrische Schicht 6 aus SiO₂ wird in einer Dicke von zum Beispiel 8 nm gebildet. Die Dicke der ersten dielektrischen Schicht 6 ist dabei so bemessen, daß durch Spannungen von 10 Volt bis 15 Volt Tunnelströme hervorgerufen werden können, die innerhalb von Mikrosekunden bis wenigen Millisekunden so viel Ladung auf ein später herzustellendes floatendes Gate übertragen, daß bei dem darunter befindlichen MOS-Transistor die Schwellenspannung Vₜ die Versorgungsspannung V_{dd} übersteigt.

Anschließend wird eine erste Polysiliziumschicht 7 in einer Dicke von zum Beispiel 100 nm bis 250 nm abgeschieden. Die erste Polysiliziumschicht 7 wird n-dotiert. Dieses kann entweder in situ während des Abscheidens erfolgen oder nach dem Abscheiden durch eine Phosphordiffusion. Die erste Polysiliziumschicht 7 weist eine im wesentlichen konforme Kantenbedeckung auf, so daß deren Dicke auf der Hauptfläche 3 und am Grabenboden im wesentlichen gleich groß ist wie an der Oberfläche der SiO₂-Spacer 5 (siehe Figur 1).

Auf die dotierte erste Polysiliziumschicht 7 wird eine Si₃N₄-Schicht in einer Dicke von zum Beispiel 20 nm bis 50 nm aufgebracht. Die Si₃N₄-Schicht weist eine im wesentlichen konforme Kantenbedeckung auf. Es wird eine anisotrope Ätzung zum Beispiel mit CHF₃ durchgeführt, bei der die in den planaren Bereichen angeordneten Teile der Si₃N₄-Schicht entfernt werden. Dabei entstehen Si₃N₄-Spacer 8, die im Bereich der Flanken der Längsgräben 4 die erste Polysiliziumschicht 7 bedecken (siehe Figur 1).

Durch eine thermische Oxidation zum Beispiel bei 850°C wird an der freiliegenden Oberfläche der ersten Polysiliziumschicht 7 selektiv eine SiO₂-Struktur 9 erzeugt (siehe Figur 1). Da nach der Bildung der Si₃N₄-Spacer 8 die erste Polysiliziumschicht 7 im Bereich der Hauptfläche 3 und am Boden der Längsgräben 4 freigelegt wurde, bedeckt die SiO₂-Struktur 9 die erste Polysiliziumschicht 7 im Bereich der Hauptfläche 3 und am Boden der Längsgräben 4.

Nachfolgend werden die Si₃N₄-Spacer 8 selektiv zu der SiO₂-Struktur 9 entfernt. Dieses erfolgt zum Beispiel naßchemisch mit Hilfe von heißer Phosphorsäure. Dabei werden im Bereich der Flanken der Längsgräben 4 angeordnete Teile der ersten Polysiliziumschicht 7 freigelegt.

Unter Verwendung der SiO₂-Struktur 9 als Ätzmaske wird die erste Polysiliziumschicht 7 durch eine trockene Ätzung, die mit einer naßen Ätzung kombiniert werden kann, strukturiert. Dabei entstehen erste Polysiliziumstrukturen 7'. Die Ätzung erfolgt zum Beispiel mit Cl₂ oder mit HF/HNO₃. Bei der Strukturierung der ersten Polysiliziumschicht 7 werden diejenigen Teile der ersten Polysiliziumschicht 7 entfernt, die im Bereich der Flanken der Längsgräben 4 angeordnet sind. Die ersten Polysiliziumstrukturen 7' sind daher streifenförmig und jeweils im Bereich der Hauptfläche zwischen benachbarten Längsgräben 4 sowie am Boden der Längsgräben 4 angeordnet (siehe Figur 2). Die Breite der ersten Polysiliziumstrukturen 7', die am Boden der Längsgräben 4 angeordnet sind, ist dabei geringer als es der Weite der Längsgräben 4 entspricht. Die Breite der ersten Polysiliziumstrukturen 7' in den Längsgräben 4 wird über die Dicke der ersten Polysiliziumschicht 7 und die Breite der Spacer 8 eingestellt. Die Bildung der ersten Polysiliziumstrukturen 7' erfolgt selbstjustierend, das heißt, ohne Einsatz von Photolithographie.

Durch eine trockene Ätzung, zum Beispiel mit CF₄ wird die SiO₂-Struktur 9 entfernt. Die Ätzung erfolgt vorzugsweise selektiv zu Polysilizium. Bei dieser Ätzung, die mit einer naßen Si0₂-Ätzung selektiv zu Silizium kombiniert werden kann, werden auch die SiO₂-Spacer 5 an den Seitenwänden der Gräben entfernt.

Anschließend werden durch Abscheiden einer SiO₂-Schicht in einem TEOS-Verfahren mit einer Schichtdicke von zum Beispiel 20 nm bis 50 nm und einer anisotropen Spacerätzung wiederum SiO₂-Spacer 10 an den Seitenwänden der Längsgräben 4 gebildet (siehe Figur 3). Zwischen den Polysiliziumstrukturen 7' und den SiO₂-Spacern 10 werden Isolationsstrukturen 11 gebildet, die am Grabenboden angeordnet sind. Die Isolationsstrukturen 11 werden zum Beispiel aus SiO₂ gebildet. Die Höhe der Isolationsstrukturen 11 ist dabei geringer als die Höhe der Polysiliziumstrukturen 7', so daß die Flanken der ersten Polysiliziumstrukturen 7' teilweise freiliegen.

Die Isolationsstrukturen 11 werden zum Beispiel durch Abscheidung eines verfließbaren Oxids, zum Beispiel Borsilikatglas oder TEOS-SiO₂, und anschließendem Verfließen gebildet. Alternativ wird der Zwischenraum zwischen der ersten Polysiliziumstruktur 7' und den SiO₂-Spacern 10 durch Abscheidung einer TEOS-SiO₂-Schicht aufgefüllt. Die Isolationsstrukturen 11 werden anschließend durch Rückätzen dieser SiO₂-Schicht gebildet.

Nach einer reduzierenden Reinigung wird die freiliegende Oberfläche der ersten Polysiliziumstruktur 7' mit einer zweiten dielektrischen Schicht 12 versehen. Die zweite dielektrische Schicht 12 wird zum Beispiel durch thermische Oxidation aus SiO₂ in einer Schichtdicke von zum Beispiel 14 nm gebildet. Alternativ wird die zweite dielektrische Schicht 12 als Mehrfachschicht mit einer SiO₂- Si₃N₄-SiO₂-Schichtenfolge gebildet. Dazu wird zunächst eine SiO₂-Schicht in einer Schichtdicke von zum Beispiel 5 nm abgeschieden. Darauf wird eine Si₃N₄-Schicht in einer Schichtdicke von zum Beispiel 6 nm abgeschieden. Abschließend wird durch thermische Oxidation eine weitere SiO₂-Schicht in einer Schichtdicke von zum Beispiel 5 nm gebildet. Eine weitere Möglichkeit für ein geeignetes zweites Dielektrikum besteht in der Verwendung von nitridiertem Oxid.

Anschließend wird eine zweite Polysiliziumschicht abgeschieden. Die zweite Polysiliziumschicht wird in einer Dicke, die größer als die halbe Breite der Längsgräben 4 ist, gebildet. Dadurch weist die zweite Polysiliziumschicht eine im wesentlichen planare Oberfläche auf. Die zweite Polysiliziumschicht wird in einer Dicke von zum Beispiel 300 nm gebildet.

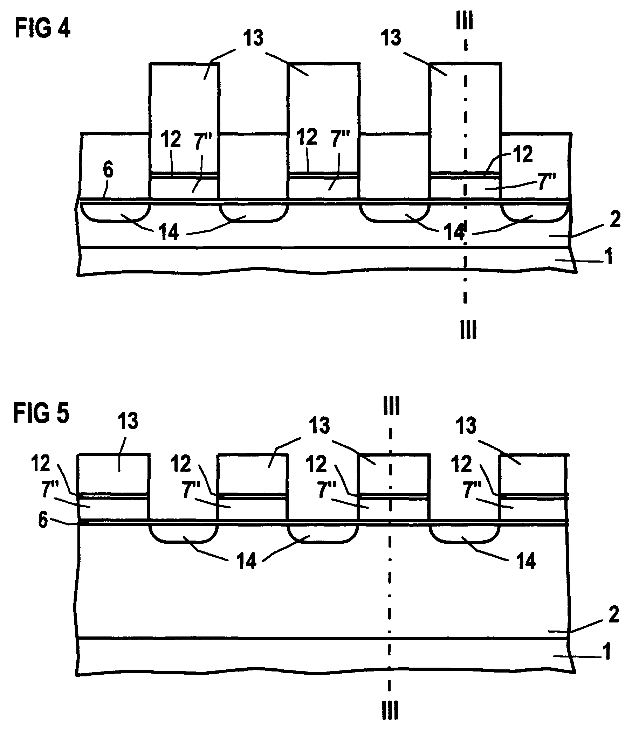

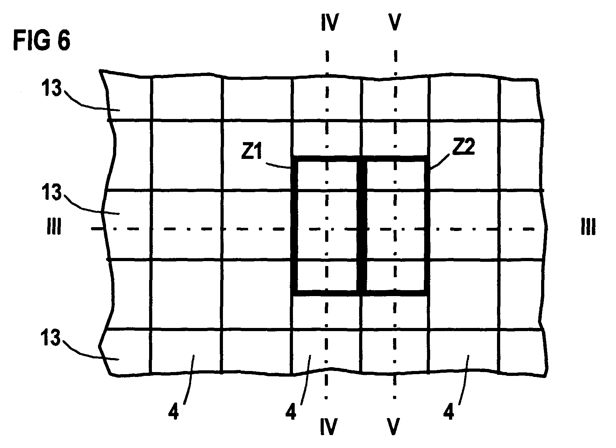

Nach Bildung einer Photolackmaske (nicht dargestellt) wird die zweite Polysiliziumschicht durch anisotropes Ätzen strukturiert. Dabei werden Wortleitungen 13 gebildet, die quer zu den Längsgräben 4 verlaufen (siehe Figur 3). Die anisotrope Ätzung der zweiten Polysiliziumschicht erfolgt zum Beispiel mit Cl₂. Durch Änderung des Ätzmediums in CF₄ wird mit derselben Photolackmaske die zweite dielektrische Schicht 10 strukturiert. Durch erneute Änderung des Ätzmediums Cl₂ wird die erste Polysiliziumstruktur 7' nochmals strukturiert, wobei die Oberfläche der ersten dielektrischen Schicht 6 und der SiO₂-Spacer 10 freigelegt wird und floating gates 7'' gebildet werden (siehe Figur 4 und Figur 5). Die Wortleitungen 13 werden in einer Breite von zum Beispiel 0,4 µm mit einem Abstand zwischen benachbarten Wortleitungen 13 von ebenfalls zum Beispiel 0,4 µm gebildet.

Nach Entfernen der Photolackmaske wird eine Source/Drain-Implantation zum Beispiel mit Arsen mit einer Energie von 25 keV und einer Dosis von 5 x 10¹⁵ cm⁻² durchgeführt. Bei der Source/Drain-Implantation werden am Boden der Längsgräben 4 sowie in der Hauptfläche 3 zwischen den Längsgräben 4 dotierte Gebiete 14 erzeugt (siehe Figur 4 und Figur 5). Die dotierten Gebiete 14 wirken jeweils als gemeinsames Source/Drain-Gebiet für zwei entlang einer Zeile angeordnete, benachbarte MOS-Transistoren. Bei der Source/Drain-Implantation werden gleichzeitig die Wortleitungen 13 dotiert.

Die Speicherzellenanordnung wird durch Abscheidung eines Zwischenoxids, in dem mit Hilfe photolithographischer Prozeßschritte Kontaktlöcher geöffnet werden, und Bildung von Kontakten durch Aufbringen einer Metallschicht zum Beispiel durch Sputtern und anschließendes Strukturieren der Metallschicht fertiggestellt. Dabei wird jede Zeile am Rand der Festwertspeicherzellenanordnung mit zwei Anschlüssen versehen, zwischen denen die in der Zeile angeordneten MOS-Transistoren in Reihe verschaltet sind (nicht dargestellt).

Bei der Strukturierung der ersten Polysiliziumstruktur 7' entstehen die floatenden Gates 7'' so, daß sie jeweils unterhalb einer Wortleitung 13 angeordnet sind. Der die Grenzfläche zur zweiten dielektrischen Schicht 12 bildende Teil der Wortleitungen 13 wirkt jeweils als Kontrollgate. Die in den Längsgräben 4 angeordneten Teile der Wortleitungen 13 füllen dabei den Zwischenraum zwischen den SiO₂-Spacern 10 und den mit der zweiten dielektrischen Schicht 12 bedeckten floatenden Gates 7'' vollständig aus.

Je zwei benachbarte dotierte Gebiete 14 und die dazwischen angeordnete Wortleitung 13 bilden jeweils einen MOS-Transistor. Der zwischen den beiden dotierten Gebieten 14 angeordnete Teil der p-dotierten Wanne 2 bildet dabei den Kanalbereich des MOS-Transistors. Oberhalb des Kanalbereiches ist die erste dielektrische Schicht 6 als Tunneloxid, das floatende Gate 7'', das zweite Dielektrikum 12 sowie ein Kontrollgate, das aus dem oberhalb des Kanalbereichs verlaufenden Teils der Wortleitung 13 gebildet wird, angeordnet.

Die Kapazität zwischen dem als Kontrollgate wirkenden Teil der Wortleitung 13 und dem floatenden Gate 7'' wird durch die Fläche der zweiten dielektrischen Schicht 12 bestimmt. Die Kapazität zwischen dem floatenden Gate 7'' und dem Kanalbereich wird durch die Grenzfläche des floatenden Gates 7'' zur ersten dielektrischen Schicht 6 bestimmt. In dem beschriebenen Beispiel wird ein Coupling ratio, das heißt das Verhältnis der Kapazität zwischen Kontrollgate und floatendem Gate sowie der Kapazität zwischen floatendem Gate und Kanalbereich, im Bereich von 1,5 bis 2 erzielt.

Am Boden der Längsgräben 4 sowie zwischen den Längsgräben 4 im Bereich der Hauptfläche 3 ist jeweils eine Zeile von in Reihe verschalteten Transistoren, die jeweils aus zwei dotierten Gebieten 14 und der dazwischen angeordneten Wortleitung 13 gebildet sind, angeordnet. Die am Boden eines Längsgrabens 4 angeordneten MOS-Transistoren sind von den benachbarten, zwischen den Längsgräben 4 an der Hauptfläche 3 angeordneten MOS-Transistoren durch den SiO₂-Spacer 10 isoliert.

Die Breite der Längsgräben 4, der Abstand zwischen benachbarten Längsgräben 4, die Breite der Wortleitungen 13 sowie der Abstand zwischen benachbarten Wortleitungen 13 wird jeweils vorzugsweise mit einer Abmessung entsprechend einer in der jeweiligen Technologie minimal herstellbaren Strukturgröße F gebildet. Berücksichtigt man, daß jedes der dotierten Gebiete 14 Source/Drain-Gebiet für zwei angrenzende MOS-Transistoren ist, so beträgt die Länge jedes MOS-Transistors parallel zum Verlauf der Längsgräben 4 2F. Die Breite der MOS-Transistoren beträgt jeweils F. Herstellungsbedingt beträgt die Fläche für eine aus einem MOS-Transistor gebildete Speicherzelle daher 2F². Entlang einer Wortleitung 13 benachbarte Speicherzellen, deren Konturen Z1, Z2 in der Aufsicht in Figur 6 als verstärkte Linie eingezeichnet sind, grenzen in der Projektion auf die Hauptfläche 3 unmittelbar aneinander. Die Speicherzelle Z1 ist am Boden eines der Längsgräben angeordnet, die Speicherzelle Z2 dagegen auf der Hauptfläche 3 zwischen zwei benachbarten Längsgräben 4. Durch die in der Höhe versetzte Anordnung benachbarter Speicherzellen wird die Packungsdichte erhöht, ohne daß die Isolation zwischen benachbarten Speicherzellen verschlechtert würde.

Die Programmierung der elektrisch schreib- und löschbaren Festwertspeicherzellenanordnung erfolgt durch Injektion von Elektronen vom Kanalbereich des jeweiligen MOS-Transistors auf das zugehörige floatende Gate 7''. Je nach auf dem floatenden Gate 7'' befindliche elektrische Ladung weist der entsprechende MOS-Transistor eine niedrige oder eine hohe Schwellwertspannung auf. Eine hohe Schwellenspannung, die einem ersten logischen Wert zugeordnet wird, wird durch eine positive Spannung von zum Beispiel 10 bis 15 Volt hervorgerufen, die zwischen die als Kontrollgate wirkende Wortleitung 13 und die p-dotierte Wanne 2, die gegen das Substrat 1 durch einen pn-Übergang isoliert ist, angelegt wird. Diese Spannung bewirkt, daß über einen Fowler-Nordheim-Tunnel-Strom Elektronen auf das floatende Gate injiziert werden.

Ein zweiter logischer Wert wird einer niedrigen Schwellenspannung zugeordnet. Dazu wird das entsprechende floatende Gate 7'' entladen. Dieses erfolgt durch Anlegen eines negativen Potentials von -10 bis -15 Volt zwischen die p-dotierte Wanne 2 und das Kontrollgate 13. Dadurch wird ein Tunnelstrom durch die erste dielektrische Schicht 6 bewirkt, über den die Elektronen von den floatenden Gates 7'' innerhalb von Mikrosekunden bis wenigen Millisekunden abfließen.

Durch Verwendung mehrerer Spannungsniveaus bei der Injektion von Elektronen auf das floatende Gate 7'' kann die elektrisch schreib- und löschbare Speicherzellenanordnung auch im Sinne einer Mehrwertlogik programmiert werden.

## Patentansprüche

1. Verfahren zur Herstellung einer elektrisch schreib- und löschbaren Festwertspeicherzellenanordnung,
- bei dem in einer Hauptfläche (3) eines Halbleitersubstrates (1) ein von einem ersten Leitfähigkeitstyp dotiertes Gebiet (2) erzeugt wird, das gegenüber dem Halbleitersubstrat (1) isoliert ist,
- bei dem in der Hauptfläche (3) innerhalb des vom ersten Leitfähigkeitstyp dotierten Gebietes (2) im wesentlichen parallel verlaufende Längsgräben (4) geätzt werden,
- bei dem eine Vielzahl in Zeilen angeordneter Speicherzellen, die jeweils mindestens einen MOS-Transistor mit von einem zweiten, dem ersten entgegengesetzten Leitfähigkeitstyp dotierten Source/Drain-Gebieten (14), einem ersten Dielektrikum (6), einem floatenden Gate (7''), einem zweiten Dielektrikum (12) und einem Kontrollgate (13) umfassen, erzeugt werden, wobei die Zeilen abwechselnd an der Hauptfläche (3) zwischen benachbarten Längsgräben (4) und am Boden der Längsgräben (4) angeordnet sind,
- bei dem eine erste dielektrische Schicht (6) erzeugt wird,
- bei dem eine erste dotierte Polysiliziumschicht (7) erzeugt wird,
- bei dem durch Abscheiden und zum Halbleitersubstrat (1) selektives, anisotropes Ätzen einer ersten Hilfsschicht an den an den Flanken der Längsgräben (4) angeordneten Teilen der ersten Polysiliziumschicht (7) Spacer (8) gebildet werden,
- bei dem auf freiliegenden Teilen der ersten Polysiliziumschicht (7) eine zweite Hilfsschicht (9) erzeugt wird, zu der die erste Hilfsschicht und die erste Polysiliziumschicht (7) selektiv ätzbar sind,
- bei dem die Spacer (8) selektiv zur zweiten Hilfsschicht (9) entfernt werden,
- bei dem durch Ätzen der ersten Polysiliziumschicht (7) unter Verwendung der zweiten Hilfsschicht (9) als Ätzmaske streifenförmige erste Polysiliziumstrukturen (7') gebildet werden, die parallel zu den Längsgräben (4) jeweils an der Hauptfläche (3) zwischen benachbarten Längsgräben (4) und am Boden der Längsgräben (4) angeordnet sind, wobei die Breite der am Boden der Längsgräben (4) angeordneten ersten Polysiliziumstrukturen (7') geringer als die Grabenweite ist, so daß in den Längsgräben (4) die Flanken der ersten Polysiliziumstruktur (7') freiliegen,
- bei dem die zweite Hilfsschicht (9) entfernt wird,
- bei dem Isolationsstrukturen (11) gebildet werden, die am Boden der Längsgräben (4) jeweils zwischen der dort angeordneten ersten Polysiliziumstruktur (7') und den Grabenwänden angeordnet sind und deren Höhe geringer ist als die Höhe der ersten Polysiliziumstrukturen (7'),
- bei dem eine zweite dielektrische Schicht (12) erzeugt wird,
- bei dem durch Abscheiden und Strukturieren einer zweiten Polysiliziumschicht Kontrollgates (13), die auch die Flanken der in den Längsgräben (4) angeordneten ersten Polysiliziumstrukturen (7') bedecken, und quer zu den Zeilen verlaufende Wortleitungen (13) erzeugt werden, die jeweils mit den Kontrollgates von entlang unterschiedlichen Zeilen angeordneten MOS-Transistoren verbunden sind,
- bei dem zur Bildung der floatenden Gates (7'') die zweite dielektrische Schicht (12) und die erste Polysiliziumstruktur (7') durch anisotropes Ätzen entsprechend den Wortleitungen (13) strukturiert werden,
- bei dem eine Source/Drain-Implantation für die MOS-Transistoren durchgeführt wird, bei der die Wortleitungen (13) als Maske wirken.

2. Verfahren nach Anspruch 1,
bei dem vor der Bildung der ersten dotierten Polysiliziumschicht (7) an den Seitenwänden der Längsgräben Spacer (5) gebildet werden.

3. Verfahren nach Anspruch 1 oder 2,
bei dem die zweite Hilfsschicht (9) aus thermischem Siliziumoxid und die erste Hilfsschicht aus Siliziumnitrid oder aus Siliziumoxid, das zu thermischem Siliziumoxid selektiv ätzbar ist, gebildet werden.
